# FASCICULE DE BREVET EUROPEEN

(11) **EP 1 940 731 B1**
(45) Date de publication et mention de la délivrance du brevet: **02.05.2012**
(21) Numéro de dépôt: 06819141.0
(22) Date de dépôt: 25.10.2006
(51) Int. Cl.: B81C 1/00

(54) **PROCEDE DE GRAVURE D'UNE COUCHE SACRIFICIELLE POUR UNE STRUCTURE MICRO-USINEE**
VERFAHREN ZUM ÄTZEN EINER OPFERSCHICHT FÜR EINE MIKROBEARBEITETE STRUKTUR
METHOD FOR ETCHING A SACRIFICIAL LAYER FOR A MICRO-MACHINED STRUCTURE

(30) Priorité: 27.10.2005 FR 0553271
(43) Date de publication de la demande: 09.07.2008
(73) Titulaire: Commissariat à l'Énergie Atomique et aux Énergies Alternatives, 75015 Paris (FR)
(72) Inventeur: BOREL, Stéphan, F-38400 Saint Martin d'Hères (FR); BILDE, Jérémy, F-38170 Seyssinet Pariset (FR)
(74) Mandataire: Poulin, Gérard
(86) Numéro de dépôt international: PCT/EP2006/067763
(87) Numéro de publication internationale: WO 2007/048805

(56) Documents cités:
- FR-A1- 2 865 850
- US-A1- 2003 138 986
- BOREL S ET AL: "Isotropic etching of SiGe alloys with high selectivity to similar materials" MICROELECTRONIC ENGINEERING, vol. 73-74, 14 mars 2004 (2004-03-14), pages 301-305, XP004564616 ELSEVIER PUBLISHERS BV., AMSTERDAM, NL ISSN: 0167-9317
- KIRT R WILLIAMS ET AL: "Etch Rates for Micromachining Processing", JOURNAL OF MICROELECTROMECHANICAL SYSTEMS, IEEE SERVICE CENTER, PISCATAWAY, NJ, US, vol. 5, no. 4, 1 December 1996 (1996-12-01), XP011034726, ISSN: 1057-7157
- BOREL S ET AL: "CONTROL OF SELECTIVITY BETWEEN SIGE AND SI IN ISOTROPIC ETCHING PROCESSES", JAPANESE JOURNAL OF APPLIED PHYSICS, JAPAN SOCIETY OF APPLIED PHYSICS, JP LNKD- DOI:10.1143/JJAP.43.3964, vol. 43, no. 6B, 1 June 2004 (2004-06-01), pages 3964-3966, XP001232236, ISSN: 0021-4922

## Description

### DOMAINE TECHNIQUE

L'invention concerne un procédé de gravure d'une couche sacrificielle pour une structure micro-usinée. Elle s'applique d'une manière générale à tous les cas où une couche sacrificielle enterrée doit être retirée sélectivement de manière à créer une cavité entre ses deux couches voisines.

### ÉTAT DE LA TECHNIQUE ANTÉRIEURE

La réduction des dimensions dans certains dispositifs, tels que ceux de la microélectronique, entraîne l'apparition d'effets parasites qui en limitent les performances. Pour contourner ce problème, de nouvelles architectures ont été envisagées. La réalisation de ces structures originales fait parfois appel à des matériaux inhabituels associés à des procédés novateurs. Certains de ces procédés mettent en oeuvre une couche sacrificielle pour obtenir une cavité ou pour libérer une poutre ou une membrane par exemple. Il est également possible de substituer à la couche sacrificielle une couche d'un autre matériau.

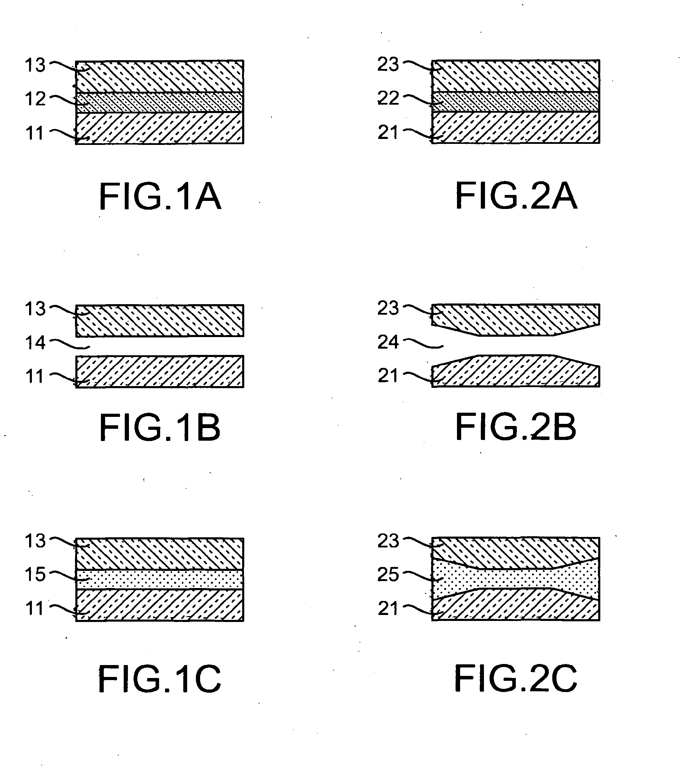

Les figures 1A à 1C sont des schémas de principe illustrant un procédé de l'art connu mettant en oeuvre une couche sacrificielle. Ces figures sont des vues de côté. Ce procédé permet par exemple l'obtention d'une structure comprenant un substrat de silicium supportant successivement une couche de SiO₂ (de 20 nm d'épaisseur par exemple) et une couche de silicium (de 15 nm d'épaisseur par exemple). L'obtention directe de cet empilement n'étant pas possible, on a recours à une couche sacrificielle de SiGe qui permet la croissance de la couche de silicium et qui est ensuite remplacée par la couche d'oxyde. Cette couche d'oxyde peut ainsi permettre d'isoler électriquement du substrat le canal d'un transistor réalisé dans la couche de silicium superficielle.

La figure 1A représente un empilement comprenant un substrat en silicium 11 supportant successivement une couche de SiGe 12 et une couche de silicium 13. La couche de SiGe est alors éliminée par gravure. On obtient la structure représentée à la figure 1B où, sur une partie de la structure (celle visible sur la figure 1B), la couche 13 est séparée du substrat 11 par un évidement ou tunnel 14. A ce stade du procédé, la structure obtenue est du type SON (de l'expression « Silicon on Nothing »). Par une technique combinant l'oxydation du silicium et un dépôt d'oxyde de silicium, la couche sacrificielle peut alors être remplacée par une couche 15 d'oxyde de silicium.

Les matériaux utilisés pour obtenir la structure précédente présentent nécessairement des caractéristiques relativement proches pour permettre d'épitaxier les différentes couches, telles que la composition chimique et l'état cristallin (par exemple Si et SiGe). Ces matériaux régissent donc de manière similaire au procédé de gravure. Ainsi, la difficulté réside dans la possibilité de ne graver que la couche sacrificielle sans dégrader les couches voisines. Le problème est d'actualité dans le domaine de la microélectronique « ultime » où les dimensions sont telles que la moindre consommation de matière ne peut être négligée. Cependant, il risque fort d'être rencontré également dans d'autres domaines tels que les microsystèmes, où les dimensions sont pour l'instant relâchées, mais tendent à utiliser des matériaux et des procédés jusque là réservés aux nano-dispositifs.

En fait, une fois la couche sacrificielle en SiGe (pouvant comprendre 30% d'atomes de Ge) gravée, le silicium environnant est partiellement gravé lui-aussi, principalement à l'entrée du tunnel. En effet, la chimie de gravure de la couche sacrificielle n'est pas inerte vis-à-vis des couches ou substrats adjacents, qui sont de composition voisine de la composition de la couche sacrificielle. Par exemple, un agent de gravure au fluor attaque le SiGe, Si et Ge réagissant tous deux avec le fluor. Par conséquent, le silicium est également partiellement attaqué pendant la gravure de la couche sacrificielle. Cette consommation du silicium survient pendant la gravure de la couche sacrificielle et au cours de l'étape de surgravure (dépassement du temps de gravure juste nécessaire au retrait de la couche sacrificielle) indispensable pour assurer une bonne uniformité de retrait de toute la couche sacrificielle. En effet, on constate que la vitesse de gravure du silicium augmente au moment de la disparition totale de la couche sacrificielle. Cette particularité se retrouve bien sûr pour d'autres matériaux que le silicium.

Les figures 2A à 2C illustrent ce qui vient d'être dit. Ce sont également des vues de côté. La figure 2A représente un empilement comprenant un substrat en silicium 21 supportant successivement une couche de SiGe 22 et une couche de silicium 23. La figure 2B montre le résultat obtenu après la gravure de la couche sacrificielle 22. La figure 2C montre le résultat obtenu après la formation de la couche d'oxyde 25. L'attaque du silicium se produit principalement aux extrémités du tunnel 24 (voir la figure 2B).

Si la sélectivité apportée par le procédé lui-même n'est pas suffisante (par l'intermédiaire de la chimie de gravure), il est nécessaire de contrôler la durée de la gravure de manière très précise afin d'éviter toute surgravure. Cette approche nécessite de nombreux essais successifs afin de déterminer le temps optimal et suppose que l'uniformité est telle que la gravure se termine au même moment en tout point de la structure, ce qui n'est vraisemblablement pas le cas.

### EXPOSÉ DE L'INVENTION

L'invention permet de remédier à ce problème sus mentionné de l'art antérieur par l'utilisation d'une espèce présentant une affinité à l'agent de gravure supérieure à celle des matériaux qui ne doivent pas être gravés et inférieure ou éventuellement égale à celle de la couche sacrificielle.

L'invention a donc pour objet un procédé de gravure d'une couche sacrificielle pour une structure micro-usinée,

Le document de BOREL S ET AL: "Isotropic etching of SiGe alloys with high selectivity to similar materials", MICROELECTRONIC ENGINEERING, vol. 73-74, 14 mars 2004 (2004-03-14), pages 301-305, ELSEVIER PUBLISHERS BV., AMSTERDAM, NL ISSN: 0167-9317, décrit un procédé de gravure sélective de couches en SiGe (dont la teneur en Ge varie) dans un empilement de couches Si/SiGe/Si. Le CF4 est choisi comme agent de gravure. Selon ce document, la gravure progresse moins vite dans les couches à faible teneur en Ge.

la structure comprenant une première couche de silicium, la couche sacrificielle en SiGe épitaxiée sur la première couche de silicium et une deuxième couche de silicium épitaxiée sur la couche sacrificielle, le procédé comprenant les étapes suivantes :
- une étape de fourniture, lors de la réalisation de la structure, d'au moins une espèce en SiGe qui est moins riche en Ge que la couche sacrificielle, l'espèce en SiGe étant sous la forme d'un matériau présent sur la structure et à proximité de la couche sacrificielle,
- puis une étape de gravure de la couche sacrificielle au moyen d'un agent de gravure qui est un gaz contenant du fluor, l'étape de gravure étant menée pour éliminer la couche sacrificielle et pour éliminer ensuite au moins partiellement ladite espèce.

Le procédé selon l'invention permet alors de graver en premier lieu la couche sacrificielle et en second lieu l'espèce ajoutée, ce qui permet de préserver les couches voisines.

Ladite espèce peut être présente sur la structure sous la forme d'un matériau solide. Elle peut être constituée par un matériau disposé à proximité de la couche sacrificielle. Ladite espèce peut être constituée par une couche d'un matériau comprise entre la couche sacrificielle et au moins l'une d'entre la première couche de silicium et la deuxième couche de silicium.

### BRÈVE DESCRIPTION DES DESSINS

L'invention sera mieux comprise, et d'autre avantages et particularités apparaîtront à la lecture de la description qui va suivre, donnée à titre d'exemple non limitatif, accompagnée des dessins annexés parmi lesquels :
- les figures 1A à 1C, déjà décrites, sont des schémas de principe illustrant un procédé de l'art connu mettant en oeuvre une couche sacrificielle,
- les figures 2A à 2C, déjà décrites, sont illustratives des défauts de gravure provoqués par le procédé de l'art connu,
- les figures 3A à 3C sont illustratives d'un procédé qui permet d'éviter des surgravures,
- les figures 4A à 4C sont illustratives d'une variante de mise en oeuvre du procédé selon la présente invention,
- les figures 5A à 5C sont illustratives d' une autre variante de mise en oeuvre du procédé selon la présente invention.

### EXPOSÉ DÉTAILLÉ DE MODES DE RÉALISATION PARTICULIERS

La présente invention consiste à introduire une espèce (ou plusieurs espèces) présentant une affinité à l'agent de gravure supérieure à celles des matériaux dont la gravure n'est pas désirée, et inférieure à celle du matériau à éliminer. Elle est destinée à solliciter les espèces gravantes, directement sous la forme d'un matériau présent sur la structure à graver, c'est-à-dire à proximité des matériaux à préserver. La réaction avec l'espèce destinée à préserver les matériaux à ne pas graver durera jusqu'à la disparition de la couche sacrificielle et empêchera ainsi les espèces gravantes d'attaquer les couches voisines de la couche sacrificielle. Si la présence du matériau formant l'espèce destinée à préserver les matériaux à ne pas graver est gênante pour la suite des opérations relatives à la structure, il est possible de s'arranger pour que ce matériau disparaisse au cours du procédé selon l'invention ou après sa mise en oeuvre.

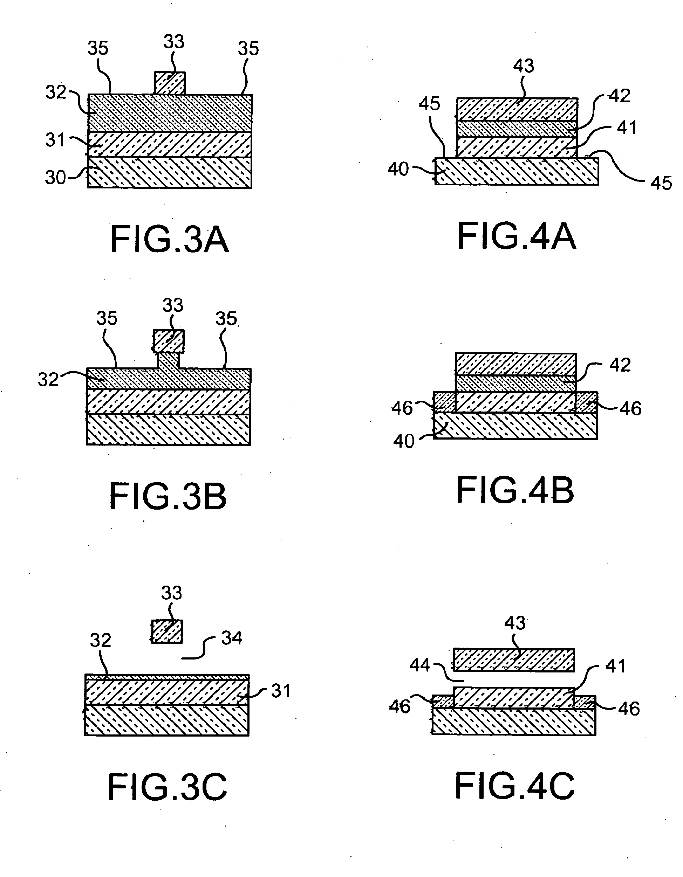

Les figures 3A à 3C sont illustratives d'un exemple qui ne fait pas partie de la présente invention. Cette variante s'applique en particulier au cas où la couche supportant la couche sacrificielle n'a pas besoin d'être traitée. Il est alors possible de procéder au retrait de la couche sacrificielle à la fois verticalement et horizontalement. L'attaque étant isotrope, la vitesse de gravure est identique dans ces deux directions. Si la largeur du motif est inférieure à l'épaisseur de la couche sacrificielle, il restera, lorsque le tunnel aura débouché, un résidu de la couche sacrificielle sur la partie inférieure de la cavité, ce résidu empêchera les couches adjacentes à la couche sacrificielle de commencer à être gravées en sollicitant les espèces gravantes.

La figure 3A montre une structure comprenant un substrat 30 en silicium supportant des couches épitaxiées 31 en silicium, 32 en SiGe et 33 en silicium. La couche 33 est déposée sur la couche 32 puis gravée pour laisser des bords libres 35 sur la couche 32. Ces bords libres 35 constituent une espèce présentant une affinité à l'agent de gravure supérieure à celle des couches 31 et 33 et égale à celle de la couche sacrificielle 32.

La figure 3B montre cette structure au cours de la gravure de la couche sacrificielle 32. Les bords 35 de la couche sacrificielle 32 se gravent en même temps que le tunnel se forme.

La figure 3C montre la structure obtenue une fois que le tunnel 34 est formé. Il subsiste des résidus de la couche sacrificielle, non visibles sur la figure 3C, sur les parois internes de la cavité.

Les figures 4A à 4C sont illustratives d'une variante de mise en oeuvre du procédé selon la présente invention. L'espèce destinée à préserver les matériaux à ne pas graver et destinée à solliciter les espèces gravantes, est introduite sous la forme d'un matériau présent sur la structure à graver.

La figure 4A montre une structure comprenant un substrat 40 en silicium supportant des couches épitaxiées 41 en silicium, 42 en SiGe (c'est la couche sacrificielle) et 43 en silicium. L'empilement des couches 41, 42 et 43 laisse subsister des bords 45 sur le substrat 40.

La figure 4B montre la structure précédente comprenant en outre sur les bords 45 du substrat 40 un matériau 46 constituant une espèce présentant une affinité à l'agent de gravure supérieure à celle des couches 41 et 43 et inférieure à celle de la couche sacrificielle. Le matériau 46 est un alliage de SiGe moins riche en Ge que l'alliage de la couche 42. Comme la vitesse de gravure augmente avec le pourcentage de Ge, l'attaque se produit d'abord au niveau de la couche 42, puis au niveau du matériau 46 et ne se produit pas sur les couches 41 et 43 tant qu'il reste du matériau 46 (voir la figure 4C).

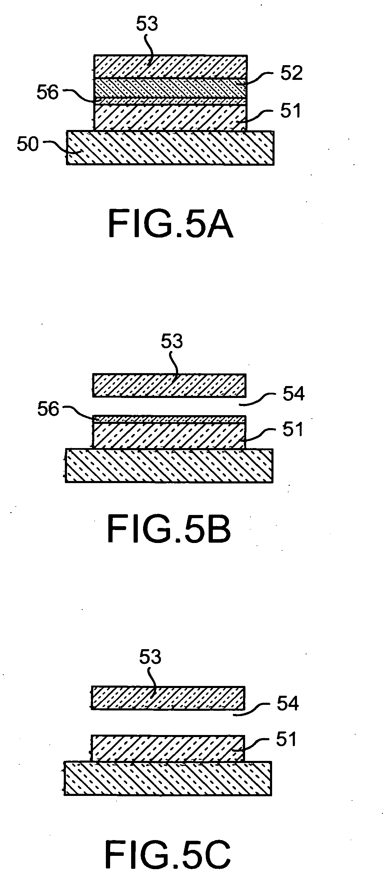

Les figures 5A à 5C sont illustratives d'une autre variante de mise en oeuvre du procédé selon la présente invention. L'espèce destinée à préserver les matériaux à ne pas graver et destinée à solliciter les espèces gravantes, est introduite sous la forme d'un matériau présent sur la structure à graver.

La figure 5A montre une structure comprenant un substrat 50 en silicium supportant des couches épitaxiées 51 en silicium, 56 en un premier alliage de SiGe, 52 en un deuxième alliage de SiGe (c'est la couche sacrificielle) et 53 en silicium. La couche 56 de SiGe est moins riche en Ge que la couche 52. Le matériau de la couche 56 constitue une espèce présentant une affinité à l'agent de gravure supérieure à celles des couches 51 et 53 et inférieure à celle de la couche sacrificielle 52.

La figure 5B montre la structure obtenue après gravure du tunnel 54 et juste avant la gravure de la couche 56. La gravure peut se poursuivre de manière à ne laisser qu'un résidu de matériau 56 sur la couche 51 (voir la figure 5C). La couche 56 peut être conservée après la réalisation du tunnel 54. En effet, elle n'interfère absolument pas avec la couche 53 qui est habituellement la couche active, puisqu'elle est déposée sur la couche 51.

## Revendications

1. Procédé de gravure d'une couche sacrificielle (42, 52) pour une structure micro-usinée, la structure comprenant une première couche de silicium (41, 51) , la couche sacrificielle (42, 52) en SiGe épitaxiée sur la première couche de silicium (41, 51) et une deuxième couche de silicium (43, 53) épitaxiée sur la couche sacrificielle (42, 52), le procédé comprenant les étapes suivantes :
- une étape de fourniture, lors de la réalisation de la structure, d'au moins une espèce en SiGe (46,56) qui est moins riche en Ge que la couche sacrificielle (42, 52), l'espèce en SiGe étant sous la forme d'un matériau présent sur la structure et à proximité de la couche sacrificielle (42, 52),
- puis une étape de gravure de la couche sacrificielle (42, 52) au moyen d'un agent de gravure qui est un gaz contenant du fluor, l'étape de gravure étant menée pour éliminer la couche sacrificielle (42, 52) et pour éliminer ensuite au moins partiellement ladite espèce (46, 56).

2. Procédé de gravure selon la revendication 1, **caractérisé en ce que** ladite espèce est présente sur la structure sous la forme d'un matériau solide (46, 56).

3. Procédé de gravure selon la revendication 2, **caractérisé en ce que** ladite espèce est constituée par un matériau (46) disposé à proximité de la couche sacrificielle (42).

4. Procédé de gravure selon la revendication 2, **caractérisé en ce que** ladite espèce est constituée par une couche d'un matériau (56) comprise entre la couche sacrificielle (52) et au moins l'une d'entre la première couche de silicium (51) et la deuxième couche de silicium (53).

## Claims

1. Method of etching a sacrificial layer (42, 52) for a micro-machined structure, the structure comprising a first silicon layer (41, 51), the sacrificial layer (42, 52) in SiGe epitaxied on the first silicon layer (41, 51) and a second silicon layer (43, 53) expitaxied on the sacrificial layer (42, 52), the method comprising the following steps:
- a step of providing, when realizing the structure, at least one species in SiGe (46, 56) which is less rich in Ge than the sacrificial layer (42, 52), the species in SiGe being in the form of a material present on the structure and near the sacrificial layer (42, 52),
- then, a step of etching the sacrificial layer (42, 52)by means of an etching agent which is a gas containing fluorine, the etching step being carried out to eliminate the sacrificial layer (42, 52) and then to eliminate at least partially said species (46, 56).

2. Etching method according to claim 1, **characterised in that** said species is present on the structure in the form of a solid material (46, 56).

3. Etching method according to claim 2, **characterised in that** said species is constituted of a material (46) arranged near to the sacrificial layer (42).

4. Etching method according to claim 2, **characterised in that** said species is constituted of a layer of a material (56) comprised between the sacrificial layer (52) and at least one of either the first silicon layer (51) and the second silicon layer (53).

## Patentansprüche

1. Verfahren zum Ätzen einer Opferschicht (42, 52) für eine mikrobearbeitete Struktur, wobei die Struktur eine erste Siliziumschicht (41, 51) umfasst, die Opferschicht (42, 52) aus SiGe auf die erste Siliziumschicht (41, 51) epitaxiert wird und eine zweite Siliziumschicht (43, 53) auf die Opferschicht epitaxiert wird, das Verfahren umfassend:
- einen Bereitsteilungsschritt vor der Herstellung der Struktur, von wenigstens einem Stück SiGe (46, 56), das weniger Ge als die Opferschicht (42, 52) enthält, wobei das Stück SiGe, in der Form eines Materials auf der Struktur und in der Nähe der Opferschicht (42, 52) vorliegt, und
- einen Ätzschritt der Opferschicht (42, 52) mittels eines Ätzmittels, das ein flourhaltiges Gas ist, wobei der Ätzschritt durchgeführt wird, um die Opferschicht (42, 52) abzutragen und anschließend zumindest teilweise das Stück (46, 56) abzutragen.

2. Verfahren nach Anspruch 1, **dadurch gekennzeichnet, dass** das Stück auf der Struktur in Form eines Feststoffs (46, 56) vorliegt.

3. Verfahren nach Anspruch 2, **dadurch gekennzeichnet, dass** das Stück aus einem Material (46) besteht, das nahe der Opferschicht (42) bereitgestellt ist.

4. Verfahren nach Anspruch 2, **dadurch gekennzeichnet, dass** das Stück aus einer Materialschicht (56) besteht, die zwischen der Opferschicht (52) und zwischen wenigstens einer von entweder der ersten Siliziumschicht (51) oder der zweiten Siliziumschicht (53) eingefasst ist.
